# EUROPEAN PATENT APPLICATION

(11) **EP 4 788 066 A1**
(43) Date of publication of application: **05.08.2026**
(21) Application number: 25155632.0
(22) Date of filing: 03.02.2025
(51) Int. Cl.: H05K 1/02, H05K 3/34

(54) **SOLDER JOINT COOLING SYSTEM**

(71) Applicant: Delta Electronics (Thailand) Public Co., Ltd., Samutprakarn 10280 (TH)
(72) Inventor: BROWN, Mathew, Crook, County Durham, DL 15 8EF (GB); O'NEILL, Craig, Paisley, Renfrewshire, PA1 3EG (GB)
(74) Representative: Keller Schneider Patent- und Markenanwälte AG

(57) **Abstract**

The invention relates to a solder joint cooling system, comprising 1) a printed circuit board (4) comprising a through hole through which a lead (3) of an electrical component (1) is inserted, wherein the printed circuit board (4) comprises at least one conductive layer and at least one insulating layer, with the printed circuit board (4) comprising a component side (5) and a solder side (6) opposite the component side (5), wherein a first conductive layer of the at least one conductive layer is arranged on the solder side (6) of the printed circuit board (4), 2) the electrical component (1), wherein the electrical component (1) is mounted on the component side (5) of the printed circuit board (4) and the lead (3) of the electrical component (1) is soldered to a pad of the printed circuit board (4), which pad is positioned on the solder side (6) of the printed circuit board (4) and which pad is part of the first conductive layer, with the lead (3) being connected with a solder joint (2) to the pad, and with the pad surrounding the through hole on the solder side (6), 3) a thermally conductive enclosure portion (8) and a cooling sink (12), wherein the enclosure portion (8) is connected to the printed circuit board (4) and to the cooling sink (12), wherein the enclosure portion (8) is positioned such with respect to the printed circuit board (4) and the cooling sink (12) that the enclosure portion (8), the solder side (6) of the printed circuit board (4) and the cooling sink (12) together surround an enclosed space (11), with the solder joint (2) being inside the enclosed space (11), and wherein the enclosed space (11) is filled with a thermally conductive and electrically insulating gap filler (7), with the gap filler (7) being in contact with the cooling sink (12), with the enclosure portion (8), with the printed circuit board (4) and with the solder joint (2). The invention also relates to a method for assembling the solder joint cooling system.

## Description

### Technical Field

The invention relates to a solder joint cooling system and to a method for assembling the solder joint cooling system.

### Background Art

Solder fatigue is a well-known problem. When an electrical circuit, for example realized in a printed circuit board, is activated, current flow in the tracks of the printed circuit board, in the solder joints and in electrical components that are connected to the printed circuit board causes heating, in particular Joule heating. Repetitive heating and cooling of solder joints is known to be able to cause solder joint fatigue after a number of thermal cycles, with a thermal cycle corresponding to consecutive heating and then cooling of a solder joint.

During a thermal cycle, solder may experience fatigue due to induced stresses developed by a mismatch in the coefficient of thermal expansion between solder, tracks of the printed circuit board, the electrical component, any other material of the printed circuit board and/or any other adjacent materials. Such stresses often lead to solder deformation and damage accumulation, in turn resulting in crack nucleation and propagation within the solder joint; after further thermal cycling, the solder joint may completely fail and thereby result in an unintended open circuit in a printed circuit board.

To address solder fatigue, the use of improved solder materials has been considered in the prior art. Examples of such improved solder materials that show less susceptibility to solder fatigue are solder alloys that include either lead or are a tin-silver-copper (Sn-Ag-Cu) composition. Solder alloys that include lead are detrimental from a safety perspective, while tin-silver-copper compositions may be less reliable.

There is thus a need to provide a solution that helps preventing solder joint fatigue and in particular increases solder joint lifetime.

### Summary of the invention

It is the object of the invention to provide a solder joint cooling system and a method for assembling a solder joint cooling system that mitigate at least some of the disadvantages of known prior art solutions. The solution of the invention is provided by claims 1 and 12.

The invention relates to a solder joint cooling system, comprising 1) a printed circuit board comprising a through hole through which a lead of an electrical component is inserted, wherein the printed circuit board comprises at least one conductive layer and at least one insulating layer, with the printed circuit board comprising a component side and a solder side opposite the component side, wherein a first conductive layer of the at least one conductive layer is arranged on the solder side of the printed circuit board, 2) the electrical component, wherein the electrical component is mounted on the component side of the printed circuit board and the lead of the electrical component is soldered to a pad of the printed circuit board, which pad is positioned on the solder side of the printed circuit board and which pad is part of the first conductive layer, with the lead being connected with a solder joint to the pad, and with the pad surrounding the through hole on the solder side, 3) a thermally conductive enclosure portion and a cooling sink, wherein the enclosure portion is connected to the printed circuit board and to the cooling sink, wherein the enclosure portion is positioned such with respect to the printed circuit board and the cooling sink that the enclosure portion, the solder side of the printed circuit board and the cooling sink together surround an enclosed space, with the solder joint being inside the enclosed space, and wherein the enclosed space is filled with a thermally conductive and electrically insulating gap filler, with the gap filler being in contact with the cooling sink, with the enclosure portion, with the printed circuit board and with the solder joint.

The solder joint cooling system according to the invention is specifically designed to cool the solder joint through which a lead of an electrical component is connected to a pad of a printed circuit board. As solder material for the solder joint, a wide range of different solder alloy compositions may be used, i.e. the inventive solder joint cooling system is not restricted to particular types of solder alloys.

A printed circuit board in general comprises a laminated structure with conductive and insulating layers. Typically, a printed circuit board may comprise a flat sheet of insulating material forming an insulating layer and a layer of copper foil laminated to the flat sheet of insulating material, which layer of copper foil forms a conductive layer. A printed circuit board may comprise a plurality of such flat sheets of insulating material and a plurality of copper foils. Through chemical etching, a layer of copper foil may be divided for example into 1) separate conducting lines that are typically knows as tracks and/or 2) pads through which the printed circuit board may be electrically connected. The printed circuit board may also be an insulated metal substrate printed circuit board. In contrast to a conventional printed circuit board, an insulated metal substrate printed circuit board comprises a metal substrate, often made of aluminum or copper, on top of which at least one insulating layer and at least one copper foil are typically placed. An insulated metal substrate printed circuit board may be single-sided or double-sided, wherein in the double-sided case the metal substrate corresponds to a metal core and insulating layer(s) and copper foil(s) are placed on both sides of the metal substrate.

The printed circuit board used in the inventive solder joint cooling system comprises at least one conductive layer and at least one insulating layer.

The printed circuit board used in the inventive solder joint cooling system comprises a through hole, wherein the through hole may be embodied as a plated through hole or as a non-plated through hole. The through hole provides a connection between the component side and the solder side of the printed circuit board, i.e. the through hole fully traverses the printed circuit board. The pad on the solder side is part of a first conductive layer of the at least one conductive layer. Besides the first conductive layer on the solder side, the printed circuit board may comprise further conductive layers, for example arranged inside the printed circuit board and/or on the component side of the printed circuit board. On the solder side of the printed circuit board, the through hole is surrounded by the pad; the through hole traverses the pad as well, the pad therefore comprising a hole.

In case the through hole is embodied as a non-plated through hole, the pad surrounding the through hole may not be electrically connected through the through hole to other possible conductive layers of the printed circuit board. In case of a non-plated through hole, the first conductive layer of the printed circuit board may therefore typically comprise at least one track through which the pad may be electrically connected to other parts of the printed circuit board.

In case the through hole is embodied as a plated through hole, the pad surrounding the through hole may be electrically connected through the plating of walls of the through hole to further conductive layers of the printed circuit board. In case of a plated through hole, the first conductive layer of the printed circuit board may comprise at least one track that may be electrically connected to the pad; the first conductive layer of the printed circuit board may comprise no tracks, however, with the pad being electrically connected through the plating of the plated through hole to tracks of the printed circuit board that are arranged in further conductive layers.

As the enclosed space in which the solder joint is positioned is filled with a thermally conductive gap filler that adapts to the specific shape of the solder joint, heat generated in the solder joint during operation of the electrical component may be optimally transported away from the solder joint, thereby improving durability of the solder joint. As solder joints typically have varying shapes, the gap filler is preferably such that when it comes for the first time into contact with the solder joint, the gap filler is still in liquid form and may therefore adapt to a specific shape of the solder joint; afterwards, i.e. after having being brought for the first time into contact with the solder joint, the gap filler may harden. Advantageously, there is thus a maximum contact area between the solder joint and the gap filler, in turn facilitating improved cooling of the solder joint. In case the gap filler is in liquid form when the solder joint is brought for the first time into contact with the gap filler, the liquid gap filler advantageously induces substantially zero stress on the solder joint. Preferably, the gap filler fills the enclosed space fully.

Different gap fillers as known from the prior art may be used, the selected gap filler material in particular depending on an expected amount of heat that may be generated in the solder joint to be cooled during operation of the printed circuit board. As the expected heat generated in the solder joint depends in particular on currents flowing through the solder joint, in power electronic applications, for example, gap fillers with high thermal conductivity may be selected, while in applications with lower currents, gap fillers with smaller thermal conductivity may be selected. Suitable gap filler materials may further be selected based on voltages that the gap filler may be exposed to during operation of the printed circuit board. For higher voltages, electrical insulation properties of the gap filler become more important. The gap filler may be embodied as a silicone gap filler or as two-component gap fillers, for example. The gap filler may be a liquid gap filler or gap pad material.

As the gap filler is electrically insulating, unwanted electrical connections between the solder joint and thus the electrical component and the printed circuit board through the gap filler are advantageously prevented.

In the solder joint cooling system according to the invention, the electrical component is mounted on the component side of the printed circuit board. The electrical component may be embodied as, for example, an electrical connector, switch, capacitor, choke or semiconductor device, in particular for power electronics applications. The electrical component may be embodied differently as well, however. The electrical component comprises a lead, in particular a wire lead, through which lead the electrical component may be electrically connected. The lead of the electrical component is inserted through the through hole and traverses the through hole between the component side where the electrical component is positioned and the solder side where the lead is soldered to the pad with a solder joint. Accordingly, only the lead of the electrical component passes through the through hole, while the actual electrical component is arranged on the component side of the printed circuit board. Depending on the used soldering method, during soldering solder material may also flow from the solder side into the through hole and protrude out of the through hole on the component side of the printed circuit board. The solder joint cooling system according to the invention thereby cools advantageously mostly the solder joint and not the actual electrical component and therefore provides improved cooling of the solder joint.

The gap filler is arranged in an enclosed space, which enclosed space is arranged on the solder side of the printed circuit board. The closed space is surrounded by the printed circuit board, an enclosure portion and a cooling sink. Preferentially, both the enclosure portion and the cooling sink are made of a material with high thermal conductivity, in particular a metal. The cooling sink is connected to the printed circuit board via the enclosure portion. The enclosure portion may therefore rigidly connect the printed circuit board to the cooling sink. The enclosure portion and the cooling sink are positioned such that the solder joint is arranged in the enclosed space. Through the thermally conductive gap filler, heat that is generated in the solder joint in the wake of operation of the electrical component is transported to the cooling sink. The cooling sink may be part of a chassis, for example a chassis of an on-board charging system for charging electrical vehicles; more generally, the chassis may provide a housing for an electronic assembly. The cooling sink may be embodied differently as well, however.

As the gap filler is electrically insulating, unwanted electrical connections between the cooling sink and the solder joint through the gap filler are advantageously prevented.

In an embodiment of the solder joint cooling system according to the invention, the through hole is embodied as a non-plated through hole, with the first conductive layer comprising at least one track, wherein the at least one track is electrically connected to the pad and wherein the at least one track is in contact with the gap filler.

As tracks of printed circuit boards are typically made of materials such as copper that are thermally conductive, heat that is generated in the solder joint may thus be at least partly transported through the tracks of the printed circuit board that are connected to the pad.

In case these tracks are in contact with the thermally conductive and electrically insulating gap filler, advantageously an improved cooling may thus be provided.

In a further embodiment of the solder joint cooling system according to the invention, the through hole is embodied as a plated through hole, with walls of the through hole being plated with an electrically conductive material, wherein the electrically conductive material is electrically connected to the pad.

In a further embodiment of the solder joint cooling system according to the invention, the first conductive layer comprises at least one track, wherein the at least one track is electrically connected to the pad, and wherein the at least one track is in contact with the gap filler.

Through the plated through hole, electrical connections between the pad and further conductive layers of the printed circuit board may be provided. Preferentially, at least some tracks of the printed circuit board may be placed in the first conductive layer that comprises the pad. Similarly as described above for the non-plated through hole, thus advantageously improved cooling of the solder joint may be provided.

In a further embodiment of the solder joint cooling system according to the invention, the at least one conductive layer is made of copper.

In a further embodiment of the solder joint cooling system according to the invention, the enclosed space is fully surrounded, in particular in a leak-proof manner, by the printed circuit board, the enclosure portion and the cooling sink.

Even in case of a liquid gap filler, thus the gap filler may advantageously not leak from the enclosed space. This way, the solder joint cooling system may advantageously be translated and/or rotated without leakage of the gap filler. To provide for such a fully surrounded enclosed space that is leak-proof, connection points between the printed circuit board and the enclosure portion and between the enclosure portion and the cooling sink may need to be sealed.

In a further embodiment of the solder joint cooling system according to the invention, the enclosure portion is mechanically fastened with a fastening portion, with the fastening portion in particular comprising at least one screw and at least one screw thread, to the printed circuit board, wherein the at least one screw thread is in particular arranged in the enclosure portion.

In a further embodiment of the solder joint cooling system according to the invention, the fastening portion provides an electrical connection between the enclosure portion and a ground of the printed circuit board.

The fastening portion may advantageously thus provide electrical grounding of the enclosure portion as it may electrically connect the enclosure portion to a grounding circuity of the printed circuit board. In case the enclosure portion is connected in an electrically conductive manner to the cooling sink, the grounding circuitry of the printed circuit board may have a same electrical potential as the cooling sink. A screw of the fastening portion may pass through a plated via of the printed circuit, which plated via may provide an electrical connection between grounding circuitry and the screw; the screw in turn may be electrically connected to the screw thread.

In a further embodiment of the solder joint cooling system according to the invention, the enclosure portion is fastened to the printed circuit board with a glue, in particular an electrically insulating glue, and/or a sealant, in particular an electrically insulating sealant.

Glue and/or sealant may further fasten the enclosure portion to the printed circuit board and may further help in making the enclosed space leak-proof. Glue and/or sealant may be combined with a fastening portion providing mechanical fastening. In case it is desired to provide no electrically conductive connection between the enclosure portion and the solder side of the printed circuit board, the glue and/or the sealant may be provided as electrically insulating glue and/or electrically insulating sealant.

In a further embodiment of the solder joint cooling system according to the invention, the cooling sink is part of a chassis.

In a further embodiment of the solder joint cooling system according to the invention, the enclosure portion and the cooling sink are integrally formed in one piece, or the enclosure portion is fastened to the cooling sink, in particular mechanically fastened with at least one screw and at least one screw thread and/or fastened with a glue and/or a sealant, or the enclosure portion is welded to the cooling sink.

In case a glue and/or a sealant is used for fastening the enclosure portion to the cooling sink, a different glue and/or sealant may be used compared to the glue and/or sealant that may be used for connecting the enclosure portion and the solder side of the printed circuit board. Alternatively, a same glue and/or sealant may be used, however.

In a further embodiment of the solder joint cooling system according to the invention, the enclosed space substantially corresponds to a cuboid, with the enclosure portion providing four connected sides of the enclosed space and the printed circuit board and the cooling sink each respective providing a side of the enclosed space.

The four connected sides of the enclosed space that may be provided by the enclosure portion may each be oriented in a substantially orthogonal manner with respect to the printed circuit board. Further, any two connected neighboring sides of the four connected sides may be oriented in a substantially orthogonal manner with respect to one another. Such a solder joint cooling system may advantageously be constructed in a simple manner.

In a further embodiment of the solder joint cooling system according to the invention, the enclosure portion, in particular a surface of the enclosure portion facing away from the enclosed space, comprises a fin structure.

The enclosure portion may be embodied such that a surface area of the enclosure portion is enlarged. Through such an enlarged surface area, the enclosure portion may advantageously dissipate heat transported from the solder joint to the enclosure portion through the gap filler in an improved manner as the surface area of the enclosure portion is enlarged.

The invention also relates to a method for assembling a solder joint cooling system according to any one of the preceding claims, comprising the following steps: 1) Providing the cooling sink and the enclosure portion, with the enclosure portion being connected to the cooling sink; 2) Providing the printed circuit board and the electrical component, with the electrical component being mounted to the printed circuit board and the lead of the electrical component being soldered to the pad of the printed circuit board with a solder joint; 3) Filling up the enclosed space surrounded by the cooling sink and the enclosure portion with a gap filler in a liquid state; and subsequently 4) Connecting the printed circuit board with the mounted electrical component to the enclosure portion that is connected to the cooling sink, wherein the printed circuit board is connected such to the enclosure portion that after the connecting, the solder joint is arranged in the enclosed space and is in contact with the gap filler.

The solder joint cooling system may thus advantageously be assembled in a simple manner. The electrical component may be attached to the printed circuit board in a simple manner by inserting the lead through the through hole and then soldering the lead to the pad of the printed circuit board on the solder side. The enclosure portion may further be easily arranged on the cooling sink, for example by welding, gluing or mechanically fastening the enclosure portion to the cooling sink; alternatively, the enclosure portion and the cooling sink may be provided in one piece, i.e. the enclosure portion and the cooling sink may be integrally formed.

To assemble the solder joint cooling system, the cooling sink with the connected enclosure portion is positioned such that the gap filler in a liquid state may be inserted into the enclosed space without flowing out before the enclosed space is sufficiently filled. The cooling sink and the enclosure portion are specifically positioned such that liquid gap filler that is poured into the enclosed space, specifically poured through a side of the enclosed space where later the printed circuit board will be arranged, does not flow out from the enclosed space. In case the cooling sink surrounding the enclosed space is for example substantially planar, the cooling sink and the connected enclosure portion may be positioned such that the cooling sink is substantially orthogonal to a direction in which gravity applies and the enclosure portion is substantially parallel to the direction in which gravity applies. Once the enclosed space is filled up sufficiently, in particular fully, with liquid gap filler, the printed circuit board with the connected electrical component is connected to the enclosure portion. Specifically, the printed circuit board is connected such that the solder joint is in the enclosed space. Depending on the type of gap filler, the gap filler may subsequently harden; in case the enclosed space is leak-proof, the gap filler may alternatively also be such that it remains liquid.

In an embodiment of the method according to the invention, 1) the step 4 comprises providing sealant, in particular an electrically insulating sealant, and/or a glue, in particular an electrically insulated glue, to the enclosure portion such that after step 4 is carried out, the enclosure portion is sealed and/or glued to the printed circuit board, and/or wherein 2) the step 4 comprises mechanically fastening the printed circuit board to the enclosure portion.

### Brief description of drawings

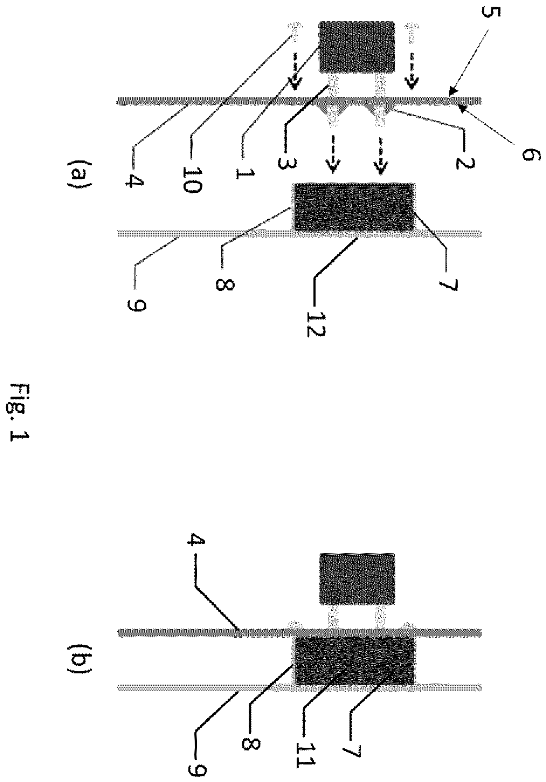

Fig. 1 shows a sectional view through an embodiment of a solder joint cooling system both during and after an assembly.

### Detailed description of drawings

Fig. 1a shows a sectional view through an embodiment of a solder joint cooling system during an assembly. An electrical component 1 comprises two leads 3. The electrical component 1 is arranged on a component side 5 of a printed circuit board 4. The two leads 3 of the electrical component 1 are inserted through two corresponding through holes in the printed circuit board 4 and soldered using a respective solder joint 2 to a respective pad of the printed circuit board arranged on the solder side 6 of the printed circuit board 4. Through the respective pad, the electrical component 1 is electrically connected to tracks of the printed circuit board; the tracks may be arranged in the same conductive layer as the pads and/or the through holes may be plated and the tracks may be arranged in further conductive layers.

In Fig. 1a, cooling sink 12 is further shown that is part of a chassis 9, in particular embodied as a chassis 9 for housing the printed circuit board 4 with the mounted electrical component 1. An enclosure portion 8 is connected to the cooling sink 12. In view of the two-dimensional nature of the drawing of Fig. 1, the enclosure portion 8 is depicted as comprising two sides, with a gap filler 7, in particular a liquid gap filler, arranged between the two sides of the enclosure portion 8 and the cooling sink 12. The underlying solder joint cooling system of which a sectional view is shown in Fig. 1 is three-dimensional, however, with the enclosure portion 8 comprising four connected sides, with any two neighboring connected sides being substantially orthogonal to one another. As such, the enclosed space between the cooling sink, the enclosure portion 8 and the printed circuit board 4 of Fig. 1 substantially corresponds to a cuboid.

As shown in Fig. 1b, after the assembly of the solder joint cooling system, the two solder joints 4 are arranged in the enclosed space 11 that is filled with the gap filler 7. The printed circuit board 4 is mechanically fastened to the enclosure portion 8 using screws 10, two of which are visible in Fig. 1, and corresponding screw threads in the enclosure portion 8. Heat generated in the solder joints 2 is transported through the gap filler 7 to the cooling sink 12.

The printed circuit board 4 with the electrical component 1 is in the embodiment substantially parallel to the cooling sink 12 and the chassis 9. Printed circuit board 4, cooling sink 12 and the four sides of the enclosure portion 8 fully surround the enclosed space 11.

## Claims

1. Solder joint cooling system, comprising 1) a printed circuit board (4) comprising a through hole through which a lead (3) of an electrical component (1) is inserted, wherein the printed circuit board (4) comprises at least one conductive layer and at least one insulating layer, with the printed circuit board (4) comprising a component side (5) and a solder side (6) opposite the component side (5), wherein a first conductive layer of the at least one conductive layer is arranged on the solder side (6) of the printed circuit board (4), 2) the electrical component (1), wherein the electrical component (1) is mounted on the component side (5) of the printed circuit board (4) and the lead (3) of the electrical component (1) is soldered to a pad of the printed circuit board (4), which pad is positioned on the solder side (6) of the printed circuit board (4) and which pad is part of the first conductive layer, with the lead (3) being connected with a solder joint (2) to the pad, and with the pad surrounding the through hole on the solder side (6), 3) a thermally conductive enclosure portion (8) and a cooling sink (12), wherein the enclosure portion (8) is connected to the printed circuit board (4) and to the cooling sink (12), wherein the enclosure portion (8) is positioned such with respect to the printed circuit board (4) and the cooling sink (12) that the enclosure portion (8), the solder side (6) of the printed circuit board (4) and the cooling sink (12) together surround an enclosed space (11), with the solder joint (2) being inside the enclosed space (11), and wherein the enclosed space (11) is filled with a thermally conductive and electrically insulating gap filler (7), with the gap filler (7) being in contact with the cooling sink (12), with the enclosure portion (8), with the printed circuit board (4) and with the solder joint (2).

2. Solder joint cooling system according to claim 1, wherein the through hole is embodied as a non-plated through hole, with the first conductive layer comprising at least one track, wherein the at least one track is electrically connected to the pad and wherein the at least one track is in contact with the gap filler (7).

3. Solder joint cooling system according to claim 1, wherein the through hole is embodied as a plated through hole, with walls of the through hole being plated with an electrically conductive material, wherein the electrically conductive material is electrically connected to the pad.

4. Solder joint cooling system according to claim 3, wherein the first conductive layer comprises at least one track, wherein the at least one track is electrically connected to the pad, and wherein the at least one track is in contact with the gap filler (7).

5. Solder joint cooling system according to any one of the preceding claims, wherein the at least one conductive layer is made of copper.

6. Solder joint cooling system according to any one of the preceding claims, wherein the enclosed space (11) is fully surrounded, in particular in a leak-proof manner, by the printed circuit board (4), the enclosure portion (8) and the cooling sink (12).

7. Solder joint cooling system according to any one of the preceding claims, wherein the enclosure portion (8) is mechanically fastened with a fastening portion, with the fastening portion in particular comprising at least one screw (10) and at least one screw thread, to the printed circuit board (4), wherein the at least one screw thread is in particular arranged in the enclosure portion (8).

8. Solder joint cooling system according to claim 7, wherein the fastening portion provides an electrical connection between the enclosure portion (8) and a ground of the printed circuit board (4).

9. Solder joint cooling system according to any one of the preceding claims, wherein the enclosure portion (8) is fastened to the printed circuit (4) board with a glue, in particular an electrically insulating glue, and/or a sealant, in particular an electrically insulating sealant.

10. Solder joint cooling system according to any one of the preceding claims, wherein the cooling sink (12) is part of a chassis (9).

11. Solder joint cooling system according to any one of the preceding claims, wherein the enclosure portion (8) and the cooling sink (12) are integrally formed in one piece, or wherein the enclosure portion (8) is fastened to the cooling sink (12), in particular mechanically fastened with at least one screw and at least one screw thread and/or fastened with a glue and/or a sealant, or wherein the enclosure portion (8) is welded to the cooling sink (12).

12. Solder joint cooling system according to any one of the preceding claims, wherein the enclosed space (11) substantially corresponds to a cuboid, with the enclosure portion (8) providing four connected sides of the enclosed space (11) and the printed circuit board (4) and the cooling sink (12) each respectively providing a side of the enclosed space (11).

13. Solder joint cooling system according to any one of the preceding claims, wherein the enclosure portion (8), in particular a surface of the enclosure portion (8) facing away from the enclosed space (11), comprises a fin structure.

14. Method for assembling a solder joint cooling system according to any one of the preceding claims, comprising the following steps:
1) Providing the cooling sink (12) and the enclosure portion (8), with the enclosure portion (8) being connected to the cooling sink (12);
2) Providing the printed circuit board (4) and the electrical component (1), with the electrical component (1) being mounted to the printed circuit board (4) and the lead (3) of the electrical component (1) being soldered to the pad of the printed circuit board (4) with a solder joint (2);
3) Filling up the enclosed space (11) surrounded by the cooling sink (12) and the enclosure portion (8) with a gap filler (7) in a liquid state; and subsequently
4) Connecting the printed circuit board (4) with the mounted electrical component (1) to the enclosure portion (8) that is connected to the cooling sink (12), wherein the printed circuit board (4) is connected such to the enclosure portion (8) that after the connecting, the solder joint (2) is arranged in the enclosed space (11) and is in contact with the gap filler (7).

15. Method according to claim 14, wherein 1) the step 4 comprises providing a sealant, in particular an electrically insulating sealant, and/or a glue, in particular an electrically insulating glue, to the enclosure portion (8) such that after step 4 is carried out, the enclosure portion (8) is sealed and/or glued to the printed circuit board (4), and/or wherein 2) the step 4 comprises mechanically fastening the printed circuit board (4) to the enclosure portion (8).
